# EUROPEAN PATENT APPLICATION

(11) **EP 4 769 412 A1**
(43) Date of publication of application: **01.07.2026**
(21) Application number: 25203363.4
(22) Date of filing: 19.09.2025
(51) Int. Cl.: G11C 29/02, G11C 29/12, G11C 29/26

(54) **STORAGE SYSTEM HAVING ADAPTIVE CHANNEL CONFIGURATION AND OPERATING METHOD OF STORAGE CONTROLLER**

(30) Priority: 24.12.2024 KR 20240195558
(71) Applicant: Samsung Electronics Co., Ltd., Suwon-si, Gyeonggi-do 16677 (KR)
(72) Inventor: KIM, Sung Woo, 16677 Suwon-si (KR); SHIN, Hyun-Ho, 16677 Suwon-si (KR); YOUN, Ji-Seung, 16677 Suwon-si (KR); KIM, Dong Yeon, 16677 Suwon-si (KR)
(74) Representative: Marks & Clerk LLP

(57) **Abstract**

A storage system and an operating method of a storage controller are provided. The storage system includes a first memory set including a plurality of first nonvolatile memory devices and configured to communicate through a first channel, a second memory set including a plurality of second nonvolatile memory devices and configured to communicate through a second channel and a storage controller including a first interface circuit connected to the first channel and a second interface circuit connected to the second channel, wherein the storage controller measures a first signal integrity (SI) state of the first channel and a second SI state of the second channel under a preset channel operating condition, respectively, and sets the first channel to a first adjustment channel value based on the measured first SI state and sets the second channel to a second adjustment channel value based on the measured second SI state.

## Description

### BACKGROUND

A storage device is a device that stores data under the control of a host device such as a computer, a smart phone, and a smart pad. A storage device can include a device that stores data in a magnetic disk, such as a hard disk drive (HDD), and/or a device that stores data in a semiconductor memory, particularly a nonvolatile memory, such as a solid state drive (SSD) and a memory card.

The nonvolatile memory can include a Read Only Memory (ROM), a Programmable ROM (PROM), an Electrically Programmable ROM (EPROM), an Electrically Erasable and Programmable ROM (EEPROM), a flash memory, a Phase-change RAM (PRAM), a Magnetic RAM (MRAM), a Resistive RAM (RRAM), and/or a Ferroelectric RAM (FRAM).

Currently, in a storage device that uses a nonvolatile memory, a plurality of nonvolatile memory devices can be used by being connected to one storage controller. The storage controller and the nonvolatile memory device can perform communication with each other through a channel, and identify connectivity with a nonvolatile memory device connected to the channel and a Signal Integrity (SI) state.

In the nonvolatile memory device of the related art, a setting value for a channel operation is changed based on the worst channel in the identified SI state. However, based on the worst channel state, when the same channel setting value is collectively applied to the nonvolatile memory device connected to the storage controller, there is a nonvolatile memory device that is relatively damaged in an operating environment of the entire storage device. For this reason, the entire storage device may be leveled down in terms of operating performance and power by readjusted channel setting.

### SUMMARY

An object of the present disclosure is to provide a storage device with adaptive channel configuration to have improved performance and stable power efficiency even though operating environments of channels to which a nonvolatile memory device is connected are different from each other, and an operating method of the storage controller.

One implementation of the present disclosure is a storage system including a first memory set including a plurality of first nonvolatile memory devices and configured to communicate through a first channel, a second memory set including a plurality of second nonvolatile memory devices and configured to communicate through a second channel and a storage controller including a first interface circuit connected to the first channel and a second interface circuit connected to the second channel, wherein the storage controller measures a first signal integrity (SI) state of the first channel and a second SI state of the second channel under a preset channel operating condition, respectively, and sets the first channel to a first adjustment channel value based on the measured first SI state and sets the second channel to a second adjustment channel value based on the measured second SI state.

Another implementation of the present disclosure is an operating method of a storage controller, the storage controller including a first interface circuit connected to a first channel performing communication with a plurality of first nonvolatile memory devices and a second interface circuit connected to a second channel performing communication with a plurality of second nonvolatile memory devices, the operating method of the storage controller comprising: measuring an SI state for each channel operating condition of the first channel and the second channel, outputting a first adjustment channel value based on a first difference level between a first SI state of the first channel and a preset minimum SI state, outputting a second adjustment channel value based on a second difference level between a second SI state of the second channel and the preset minimum SI state, setting the first interface circuit for the first channel to the first adjustment channel value and setting the second interface circuit for the second channel to the second adjustment channel value.

The other implementation of the present disclosure is a storage system including a plurality of memory sets each including a plurality of nonvolatile memory devices, connected to each other through an independent channel and a storage controller including a plurality of interface circuits connected to the channel and configured to independently set each of the plurality of interface circuits to an adjustment channel value corresponding to an SI state during an operation of each channel, wherein the adjustment channel value is adaptively set for each channel based on a difference between an SI state during the operation of each channel and a preset minimum SI state under a preset channel operating condition.

At least some of the above and other features of the invention are set out in the claims. The objects of the present disclosure are not limited to those mentioned above and additional objects of the present disclosure, which are not mentioned herein, will be clearly understood by those skilled in the art from the following description of the present disclosure.

### BRIEF DESCRIPTION OF THE DRAWINGS

FIG. 1 is a block diagram illustrating a storage system according to one implementation of the present disclosure.
FIG. 2 is a detailed block diagram illustrating a channel of a storage device according to some implementations of the present disclosure.
FIG. 3 is a detailed block diagram illustrating a channel of a storage device according to some implementations of the present disclosure.
FIG. 4 is a graph illustrating an eye diagram that represents signal integrity (SI) characteristics of a channel.
FIG. 5 is a diagram illustrating a channel-specific eye diagram of a nonvolatile memory device according to one implementation of the present disclosure.
FIG. 6 is a detailed block diagram illustrating a storage controller according to one implementation of the present disclosure.
FIGS. 7, 8 and 9 are flow charts illustrating an operation of measuring an SI characteristic value of a storage controller according to implementations of the present disclosure.
FIG. 10 is an implementation of a table illustrating an SI state value stored in a memory of FIG. 6.
FIG. 11 is an implementation of a table illustrating an adjustment channel value stored in an optimal value storage of FIG. 6.
FIG. 12 is an eye diagram illustrating SI characteristic values when a channel-specific adjustment channel value is applied in accordance with an implementation of the present disclosure.
FIG. 13 is a block diagram illustrating a data server system according to another implementation of the present disclosure.
FIG. 14 is a diagram illustrating a system to which a storage device according to one implementation of the present disclosure is applied.

### DETAILED DESCRIPTION

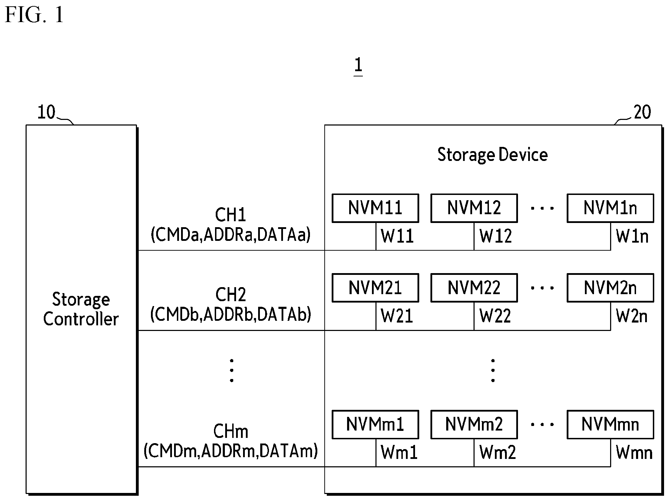

FIG. 1 is a block diagram illustrating a storage system according to one implementation of the present disclosure.

Referring to FIG. 1, a storage device 1 may include a nonvolatile memory device 20 and a storage controller 10. The storage device 1 may support a plurality of channels CH1 to CHm, and the nonvolatile memory device 20 and the storage controller 10 may be connected to each other through the plurality of channels CH1 to CHm. For example, the storage device 1 may be implemented as a storage device such as a solid state drive (SSD).

The nonvolatile memory device 20 may include a plurality of nonvolatile memory devices NVM11 to NVMmn. Each of the nonvolatile memory devices NVM11 to NVMmn may be connected to one of the plurality of channels CH1 to CHm through a corresponding way. A way may be a communication path between a nonvolatile memory device and a channel. For example, the nonvolatile memory devices NVM11 to NVM1n corresponding to a first memory set may be connected to a first channel CH1 through ways W11 to W1n, and the nonvolatile memory devices NVM21 to NVM2n corresponding to a second memory set may be connected to a second channel CH2 through ways W21 to W2n. In an example implementation, each of the nonvolatile memory devices NVM11 to NVMmn may be implemented in a random memory unit capable of operating in accordance with a separate command from the storage controller 10. For example, each of the nonvolatile memory devices NVM11 to NVMmn may be implemented as a chip or a die, but the present disclosure is not limited thereto.

In the shown example, the plurality of nonvolatile memory devices may be connected to the first memory set to an (m)th memory set through the channels CH1 to CHm, respectively, and the first to (m)th memory sets may be physical units of chips or dies.

The plurality of nonvolatile memory devices may be connected to the channels CH1 to CHm, respectively. For example, the nonvolatile memory devices may be connected to each of the channels in a chip unit, and the nonvolatile memory devices connected to different channels may be driven or implemented independently. Also, the channels CH1 to CHm respectively connected to the nonvolatile memory devices may be set independently. For example, an operating condition of each of the first channel CH1 and the second channel CH2 may be adaptively set (or be configured) depending on a channel signal integrity (SI) state.

The storage controller 10 may transmit and receive signals to and from the nonvolatile memory device 20 through the plurality of channels CH1 to CHm. For example, the storage controller 10 may transmit commands CMDa to CMDm, addresses ADDRa to ADDRm, and data DATAa to DATAm to the nonvolatile memory device 20 through the channels CH1 to CHm, or may receive the data DATAa to DATAm from the nonvolatile memory device 20.

The storage controller 10 may select one of the nonvolatile memory devices NVM11 to NVMmn, which are connected to the corresponding channels, through each channel, and may transmit and receive signals to and from the selected nonvolatile memory device. For example, the storage controller 10 may select the nonvolatile memory device NVM11 of the nonvolatile memory devices NVM11 to NVM1n connected to the first channel CH1. The storage controller 10 may transmit a command CMDa, an address ADDRa, and a data DATAa to the selected nonvolatile memory device NVM11 through the first channel CH1, or may receive the data DATAa from the selected nonvolatile memory device NVM11.

The storage controller 10 may transmit and receive signals to and from the nonvolatile memory device 20 in parallel through different channels. For example, the storage controller 10 may transmit a command CMDb to the nonvolatile memory device 20 through the second channel CH2 while transmitting the command CMDa to the nonvolatile memory device 20 through the first channel CH1. For example, the storage controller 10 may receive the data DATAb from the nonvolatile memory device 20 through the second channel CH2 while receiving the data DATAa from the nonvolatile memory device 20 through the first channel CH1.

The storage controller 10 may control the overall operation of the nonvolatile memory device 20. The storage controller 10 may control each of the nonvolatile memory devices NVM11 to NVMmn connected to the channels CH1 to CHm by transmitting a signal to the channels CH1 to CHm. For example, the storage controller 10 may control the selected one of the nonvolatile memory devices NVM11 to NVM1n by transmitting the command CMDa and the address ADDRa to the first channel CH1.

Each of the nonvolatile memory devices NVM11 to NVMmn may operate under the control of the storage controller 10. For example, the nonvolatile memory device NVM11 may program the data DATAa in accordance with the command CMDa and the address ADDRa, which are provided to the first channel CH1. For example, the nonvolatile memory device NVM21 may read the data DATAb in accordance with the command CMDb and the address ADDRb, which are provided to the second channel CH2, and may transmit the read data DATAb to the storage controller 10.

FIG. 1 illustrates that the nonvolatile memory device 20 performs communication with the storage controller 10 through 'm' channels and that the nonvolatile memory device 20 includes 'n' nonvolatile memory devices corresponding to each channel, but various modifications may be made in the number of channels and the number of nonvolatile memory devices connected to one channel.

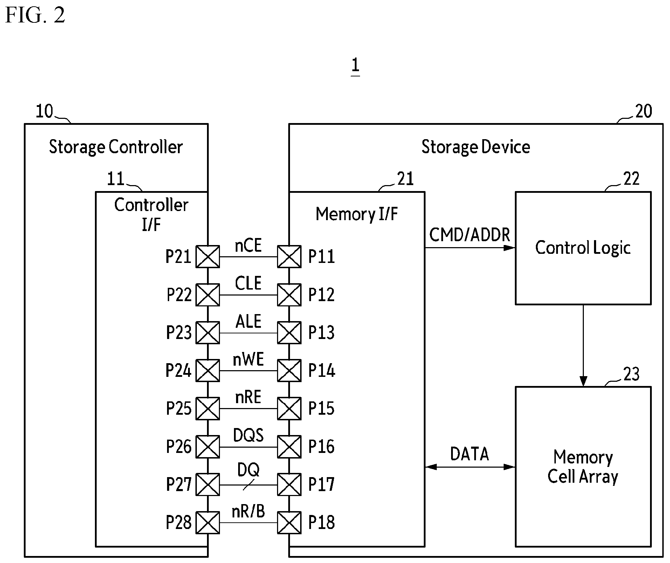

FIG. 2 is a detailed block diagram illustrating a channel of a storage device 1 according to some implementations of the present disclosure.

Referring to FIG. 2, the storage device 1 may include a nonvolatile memory device 20 and a storage controller 10. The nonvolatile memory device 20 may correspond to one of nonvolatile memory devices NVM11 to NVMmn performing communication with the storage controller 10 based on one of the plurality of channels CH1 to CHm in FIG. 1.

According to one implementation, the nonvolatile memory device 20 may include first to eighth pins P11 to P18, a memory interface circuit 21, a control logic circuit 22, and a memory cell array 23.

The memory interface circuit 21 may receive a chip enable signal nCE from the storage controller 10 through the first pin P11. The memory interface circuit 21 may transmit and receive signals to and from the storage controller 10 through the second to eighth pins P12 to P18 in accordance with the chip enable signal nCE. For example, when the chip enable signal nCE is in an enable state (e.g., low level), the memory interface circuit 21 may transmit and receive the signals to and from the storage controller 10 through the second to eighth pins P12 to P18.

The memory interface circuit 21 may receive a command latch enable signal CLE, an address latch enable signal ALE and a write enable signal nWE from the storage controller 10 through the second to fourth pins P12 to P14. The memory interface circuit 21 may receive a data signal DQ from the storage controller 10 or transmit the data signal DQ to the storage controller 10 through the seventh pin P17. The command CMD, the address ADDR and the data DATA may be transferred through the data signal DQ. For example, the data signal DQ may be transferred through a plurality of data signal lines. In this case, the seventh pin P17 may include a plurality of pins corresponding to a plurality of data signals.

The memory interface circuit 21 may acquire the command CMD from the data signal DQ received at an enable period (e.g., high level state) of the command latch enable signal CLE based on toggle timings of the write enable signal nWE. The memory interface circuit 21 may acquire the address ADDR from the data signal DQ received at an enable period (e.g., high level state) of the address latch enable signal ALE based on the toggle timings of the write enable signal nWE.

In an example implementation, the write enable signal nWE may maintain a static state (e.g., high level or low level) and then toggle between the high level and the low level. For example, the write enable signal nWE may toggle at a period at which the command CMD or the address ADDR is transmitted. Therefore, the memory interface circuit 21 may acquire the command CMD or the address ADDR based on the toggle timings of the write enable signal nWE.

The memory interface circuit 21 may receive the read enable signal nRE from the storage controller 10 through the fifth pin P15. The memory interface circuit 21 may receive a data strobe signal DQS from the storage controller 10 or transmit the data strobe signal DQS to the storage controller 10 through the sixth pin P16.

In a data DATA output operation of the nonvolatile memory device 20, the memory interface circuit 21 may generate a read enable signal nRE toggling through the fifth pin P15 before outputting the data DATA. The memory interface circuit 21 may generate a data strobe signal DQS toggling based on toggling of the write enable signal nRE. For example, the memory interface circuit 21 may generate a data strobe signal DQS that starts to toggle after a predetermined delay (for example, tDQSRE) based on a toggling start time of the read enable signal nRE. The memory interface circuit 21 may transmit the data signal DQ including data DATA based on the toggle timing of the data strobe signal DQS. Therefore, the data DATA may be aligned at the toggle timing of the data strobe signal DQS and then transmitted to the storage controller 10.

In a data DATA input operation of the nonvolatile memory device 20, when the data signal DQ including data DATA is received from the storage controller 10, the memory interface circuit 21 may receive a data strobe signal DQS toggling with the data DATA from the storage controller 10. The memory interface circuit 21 may acquire the data DATA from the data signal DQ based on the toggle timing of the data strobe signal DQS. For example, the memory interface circuit 21 may acquire the data DATA by sampling the data signal DQ at a rising edge and a falling edge of the data strobe signal DQS.

The memory interface circuit 21 may transmit a ready/busy output signal nR/B to the storage controller 10 through the eighth pin P18. The memory interface circuit 21 may transmit state information of the nonvolatile memory device 20 to the storage controller 10 through the ready/busy output signal nR/B. When the nonvolatile memory device 20 is in a busy state (that is, when internal operations of the nonvolatile memory device 20 are being performed), the memory interface circuit 21 may transmit the ready/busy output signal nR/B indicating a busy state to the storage controller 10. When the nonvolatile memory device 20 is in a ready state (that is, when internal operations of the nonvolatile memory device 20 are completed or are not performed), the memory interface circuit 21 may transmit the ready/busy output signal nR/B indicating a ready state to the storage controller 10. For example, while the nonvolatile memory device 20 reads the data DATA from the memory cell array 23 in response to a page read command, the memory interface circuit 21 may transmit the ready/busy output signal nR/B indicating a busy state (e.g., low level) to the storage controller 10. For example, while the nonvolatile memory device 20 programs the data DATA to the memory cell array 23 in response to a program command, the memory interface circuit 21 may transmit the ready/busy output signal nR/B indicating a busy state to the storage controller 10.

The control logic circuit 22 may control various operations of the nonvolatile memory device 20. The control logic circuit 22 may receive the command/address CMD/ADDR acquired from the memory interface circuit 21. The control logic circuit 22 may generate control signals for controlling other components of the nonvolatile memory device 20 in accordance with the received command/address CMD/ADDR. For example, the control logic circuit 22 may generate various control signals for programming the data DATA in the memory cell array 23 or reading the data DATA from the memory cell array 23.

According to some implementations, the operating condition of the channel may be adaptively set (or be configured) in accordance with the SI state of the channel. For example, the SI state of the channel may be set based on results of measuring the read enable signal nRE, the write enable signal nWE, the data strobe signal (for example, DQS and DQSB), and the data signal (DQ Pins).

The memory cell array 23 may store the data DATA acquired from the memory interface circuit 21 under the control of the control logic circuit 22. The memory cell array 23 may output the stored data DATA to the memory interface circuit 21 under the control of the control logic circuit 22.

The memory cell array 23 may include a plurality of memory cells. For example, the plurality of memory cells may be flash memory cells, but the present disclosure is not limited thereto. The memory cells may be resistive random access memory (RRAM) cells, ferroelectric random access memory (FRAM) cells, phase change random access memory (PRAM) cells, thyristor random access memory (TRAM) cells, and magnetic random access memory (MRAM) cells. Hereinafter, the implementations of the present disclosure will be described based on an implementation in which the memory cells are NAND flash memory cells.

The storage controller 10 may include first to eighth pins P21 to P28 and a controller interface circuit 11. The first to eighth pins P21 to P28 may correspond to the first to eighth pins P11 to P18 of the nonvolatile memory device 20.

The storage controller 10 includes a control interface circuit 11 for each channel, which is electrically connected to each of the plurality of channels corresponding to each of the plurality of nonvolatile memory devices shown in FIG. 1 to transmit and receive a signal to and from the each of the plurality of channels. The controller interface circuit 11 may transmit the chip enable signal nCE to the nonvolatile memory device 20 through the first pin P21. The controller interface circuit 11 may transmit and receive signals to and from the nonvolatile memory device 20, which is selected through the chip enable signal nCE, through the second to eighth pins P22 to P28.

The controller interface circuit 11 may transmit the command latch enable signal CLE, the address latch enable signal ALE and the write enable signal nWE to the nonvolatile memory device 20 through the second to fourth pins P22 to P24. The controller interface circuit 11 may transmit the data signal DQ to the nonvolatile memory device 20 or receive the data signal DQ from the nonvolatile memory device 20 through the seventh pin P27.

The controller interface circuit 11 may transmit the data signal DQ, which includes the command CMD or the address ADDR, to the nonvolatile memory device 20 together with the toggling write enable signal nWE. The controller interface circuit 11 may transmit the data signal DQ, which includes the command CMD, to the nonvolatile memory device 20 in accordance with transmission of the command latch enable signal CLE having an enable state, and may transmit the data signal DQ, which includes the address ADDR, to the nonvolatile memory device 20 in accordance with transmission of the address latch enable signal ALE having an enable state.

The controller interface circuit 11 may transmit the read enable signal nRE to the nonvolatile memory device 20 through the fifth pin P25. The controller interface circuit 11 may receive the data strobe signal DQS from the nonvolatile memory device 20 or transmit the data strobe signal DQS to the nonvolatile memory device 20 through the sixth pin P26.

In the data DATA output operation of the nonvolatile memory device 20, the controller interface circuit 11 may generate the toggling read enable signal nRE, and may transmit the read enable signal nRE to the nonvolatile memory device 20. For example, the controller interface circuit 11 may generate the read enable signal nRE that is changed from a static state (e.g., high level or low level) to a toggle state before the data DATA is output. Therefore, the toggling data strobe signal DQS may be generated by the nonvolatile memory device 20 based on the read enable signal nRE. The controller interface circuit 11 may receive the data signal DQ, which includes the data DATA, from the nonvolatile memory device 20 together with the toggling data strobe signal DQS. The controller interface circuit 11 may acquire the data DATA from the data signal DQ based on the toggle timing of the data strobe signal DQS.

In the data DATA input operation of the nonvolatile memory device 20, the controller interface circuit 11 may generate the toggling data strobe signal DQS. For example, the controller interface circuit 11 may generate a data strobe signal DQS that is changed from a static state (e.g., high level or low level) to a toggle state before transmitting the data DATA. The controller interface circuit 11 may transmit the data signal DQ, which includes the data DATA, to the nonvolatile memory device 20 based on toggle timings of the data strobe signal DQS.

The controller interface circuit 11 may receive the ready/busy output signal nR/B from the nonvolatile memory device 20 through the eighth pin P28. The controller interface circuit 11 may determine state information of the nonvolatile memory device 20 based on the ready/busy output signal nR/B.

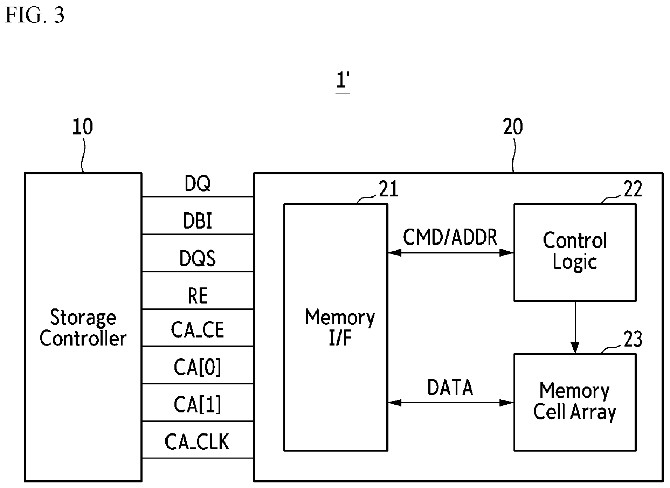

FIG. 3 is a detailed block diagram illustrating a channel of a storage device 1 according to some implementations of the present disclosure.

Referring to FIG. 3, the storage device 1 may operate in a separate command/address mode (hereinafter, referred to as SCA mode) in accordance with some implementations.

In the SCA mode, unlike the implementation described in FIG. 2, a signal line for transmitting a command and a signal line for transmitting an address are independent of each other. Since the command signal line and the address signal line are separated from each other in the SCA mode, the storage controller 10 may transmit a command or an address signal to a separate signal line even while accessing the nonvolatile memory device 20 through the DQ signal line.

The plurality of pins may transmit, for example, DQ, DBI, DQS, RE, CA_CE, CA[0], CA[1] and CA_CLK signals. Since the data signal DQ, the data strobe signal DQS and the read enable signal RE are redundant with the description of FIG. 2, their detailed description will be omitted.

The DBI signal is a data bus inversion signal, and the storage controller 10 and the nonvolatile memory device 20 may transmit and receive data for which data bus inversion computation or data masking computation has been performed. For example, the data may be encrypted for security or privacy. CA_CE is a command address chip enable signal that activates a predetermined nonvolatile memory device. CA[0] signal is a signal line for transmitting a command, CA[1] is a signal line for transmitting an address, and CA_CLK signal is a clock signal line for command and address signal lines. According to various implementations, CA[1:0] may be referred to as a command-address signal line, and the DQ signal line may be referred to as a data signal line.

The CA_CLK signal is an external clock signal provided by the storage controller 10, and the nonvolatile memory device 20 may operate based on a plurality of internal clocks by generating the plurality of internal clocks based on the CA_CLK signal as phase shifted or divided internal clocks. The CA[0] signal may operate in conjunction with any one of the plurality of internal clocks, and the CA[1] signal may operate in conjunction with another internal clock of the plurality of internal clocks.

In the implementation of FIG. 3, the signal integrity (SI) state of the channel may be set based on results of measuring, for example, the read enable signal RE, the data strobe signal DQS, the data signal DQ, and the command/address signals CA[0] and CA[1].

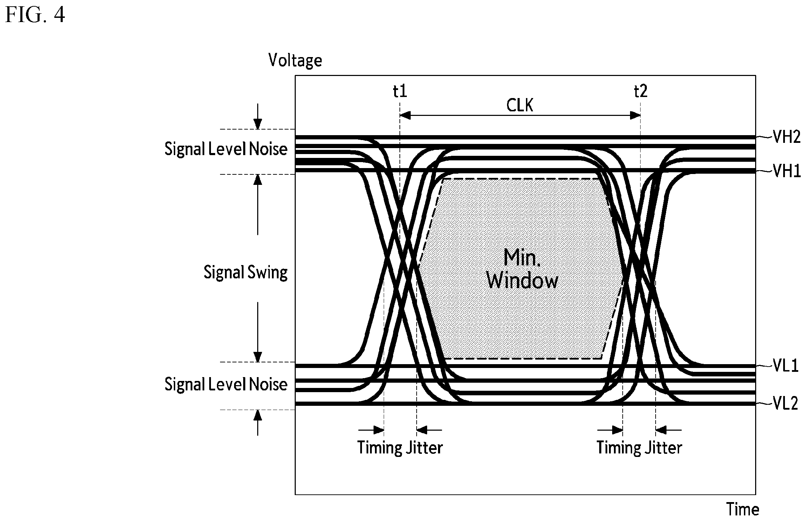

FIG. 4 is a graph illustrating an eye diagram that represents signal integrity (SI) characteristics of a channel.

Referring to FIG. 4, accumulated/overlapped voltage waveforms of a data signal may be expressed like an eye diagram on a time axis. The eye diagram shows an available signal swing area in a diamond-like hexagonal shape based on a timing jitter, a signal level noise at a logic high, and a signal level noise at a logic low within one clock period CLK.

Signal quality may be evaluated based on an eye diagram having a hexagonal minimum window. As a result, the larger the minimum window is, the better the signal quality may be, and the smaller the minimum window is, the worse the signal quality may be. Accordingly, the signal integrity characteristics may be measured based on an eye height and an eye width of the eye diagram. The eye height may correspond to the voltage difference (e.g., signal swing) across the minimum window. The eye height may correspond to the voltage difference (e.g., signal swing) across the opening of the eye diagram. The eye width may correspond to the time interval (e.g., the time difference) across the middle of the minimum window (e.g., the maximum time interval across the minimum window). The eye width may correspond to the time interval (e.g., the time difference) across the middle of the opening of the eye diagram.

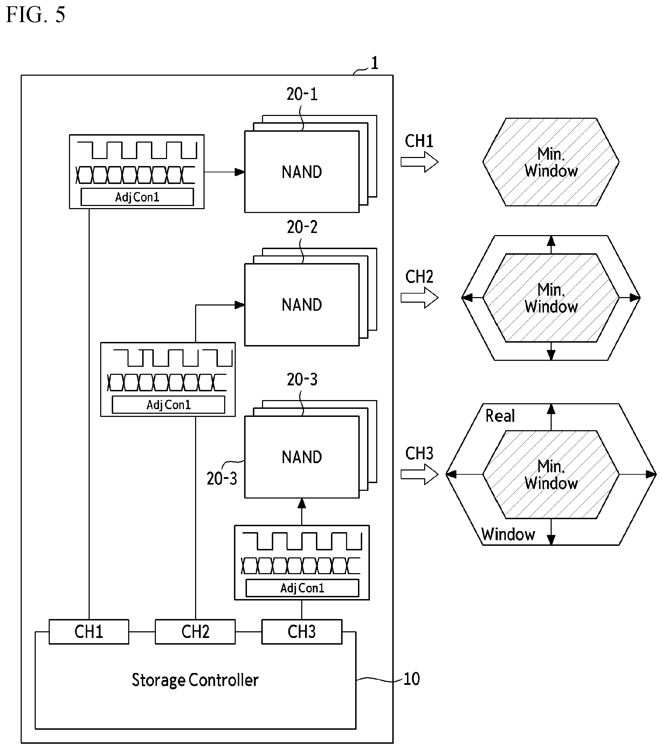

FIG. 5 is a diagram illustrating a channel-specific eye diagram of a nonvolatile memory device 20 according to one implementation of the present disclosure.

Referring to FIG. 5, first nonvolatile memory devices 20-1 are connected to the storage controller 10 through the first channel CH1. Second nonvolatile memory devices 20-2 are connected to the storage controller 10 through the second channel CH2. Third nonvolatile memory devices 20-3 are connected to the storage controller 10 through the third channel CH3.

The first nonvolatile memory devices 20-1, the second nonvolatile memory devices 20-2 and the third nonvolatile memory devices 20-3 may have different channel environments depending on locations where they are packaged in the storage device 1. For example, the first channel CH1, the second channel CH2, and the third channel CH3 may have different wiring lengths. Alternatively, for example, the first channel CH1, the second channel CH2 and the third channel CH3 may have different channel operating environments due to different electrical circuit components affecting the first nonvolatile memory devices 20-1, the second nonvolatile memory devices 20-2 and the third nonvolatile memory devices 20-3 by reflective waves or noise.

When the storage controller 10 sets the same channel operating condition Adj Con1 without considering the channel operating environment at all, each of the channels CH1, CH2 and CH3 may not have the same signal integrity (SI) characteristics due to other direct or indirect components of a corresponding channel. For example, it is assumed that an adjustment channel value Adj Con1 is calculated based on the first channel CH1 for the first nonvolatile memory device 20-1 and applied to all the remaining channels CH2 and CH3. In this case, the third channel CH3 or the second channel CH2 is adjusted so that a minimum SI characteristic value (Min. Window) has an extended SI characteristic value (Real Window) as shown, but the first channel CH1 may operate by being set to an SI characteristic value barely matched with the minimum SI characteristic value. When the adjustment channel value for the operating condition of the channel is applied equally to all the channels based on any one (e.g., the worst SI channel) of the plurality of channels connected to the storage controller 10, performance of the storage device 1 may be gradually leveled down and power consumption may be increased.

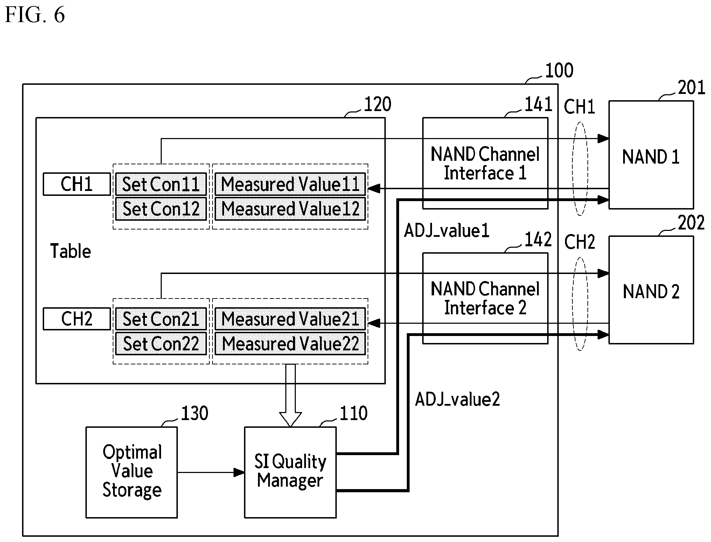

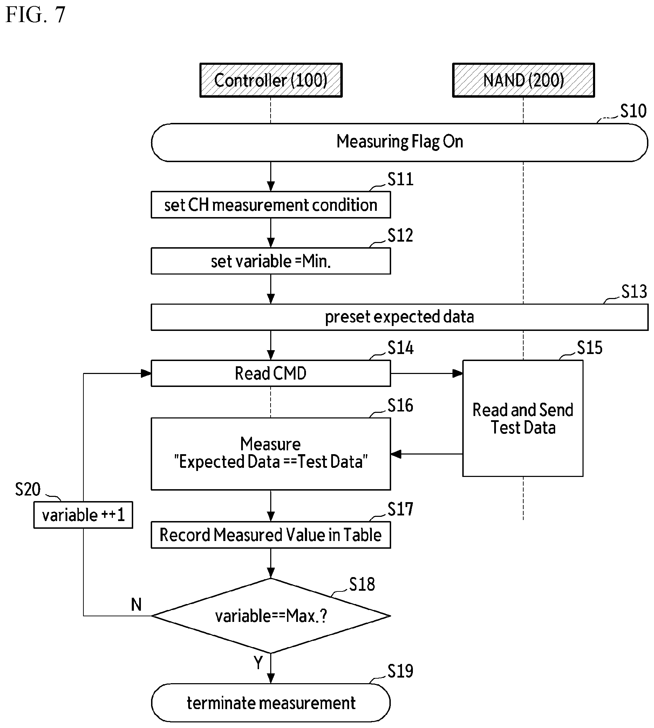

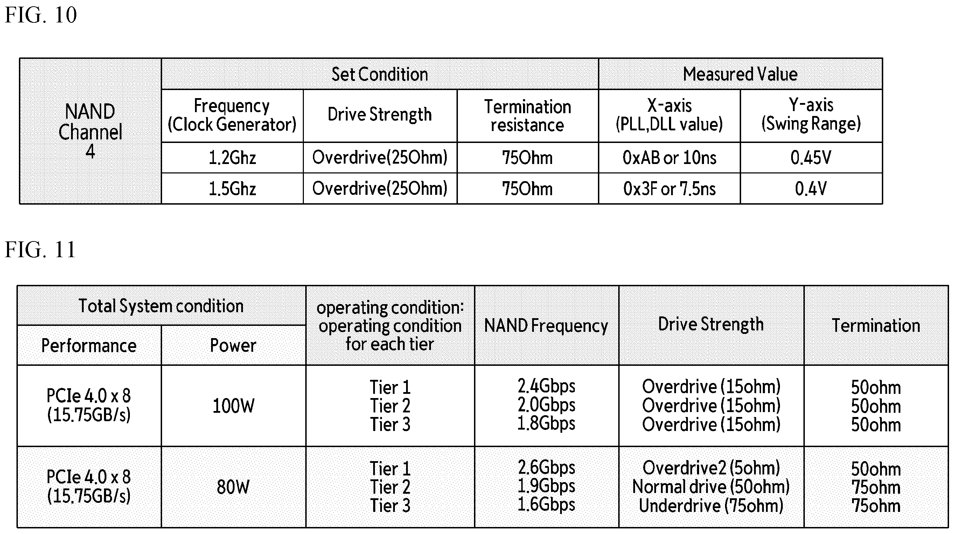

FIG. 6 is a detailed block diagram illustrating a storage controller 100 according to one implementation of the present disclosure. FIGS. 7, 8 and 9 are flow charts illustrating an operation of measuring an SI characteristic value of a storage controller according to implementations of the present disclosure. FIG. 10 is an implementation of a table illustrating an SI state value stored in a memory 120 of FIG. 6. FIG. 11 is an implementation of a table illustrating an adjustment channel value stored in an optimal value storage 130 of FIG. 6.

The storage controller 100 of FIG. 6 may be the storage controller 10 of FIGS. 1 and 2 or 3. The storage controller 100 may be connected to a first memory set 201 and a second memory set 202 through a plurality of channels CH1 and CH2. Each of the first memory set 201 and the second memory set 202 may include a plurality of nonvolatile memory devices, as shown in FIG. 1.

The storage controller 100 includes a signal integrity (SI) quality manager 110, a memory 120, an optimal value storage 130, and a plurality of interface circuits 141 and 142 allocated for each channel.

When a measurement mode is set, the SI quality manager 110 sets (e.g., configures) the first interface circuit 141 under a preset channel operating condition, and measures an SI characteristic value of the first channel in accordance with communication with the first memory set 201 connected to the first interface circuit 141. When the measurement mode is set, the SI quality manager 110 sets (e.g., configures) the second interface circuit 142 under a preset channel operating condition, and measures an SI characteristic value of the second channel in accordance with communication with the second memory set 202 connected to the second interface circuit 142.

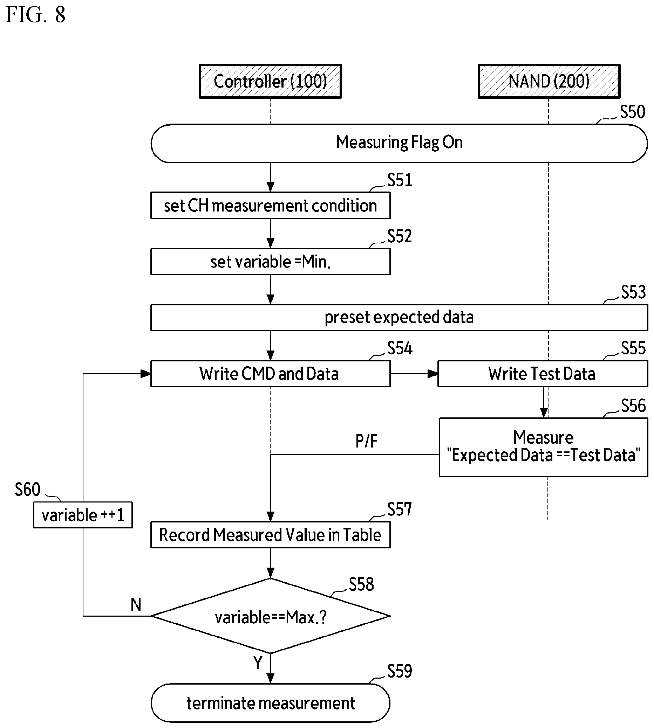

Referring to FIGS. 7 and 8, when a measurement flag is turned on (S10 and S50), the storage controller 100 may perform operations S11 to S20 and S51 to S60 in the measurement mode of measuring the SI characteristic value of the channel.

The measurement flag may be turned on, for example, when the storage device 1 is powered on, may be periodically turned on during the operation of the storage device 1, or may be turned on aperiodically by monitoring whether the operating environment in the storage controller 100 satisfies a preset environmental condition, thereby measuring the SI characteristic value of each of the channels CH1 and CH2.

First, referring to FIG. 7 for a read operation, the storage controller 100 may set a channel operating condition (S11) after the measurement flag is turned on (S10). For example, the storage controller may set a channel operating condition for measuring the interface circuit 141.

In a channel set to the channel operating condition, the storage controller 100 may measure the SI characteristic value while sweeping a variable, which affects the SI characteristic value of the SI characteristic to be measured, from a preset minimum value to a preset maximum value.

For example, for the channel characteristic measurement, an SI characteristic value of a target pin may be measured while applying a fixed signal to a reference pin and sweeping the target pin from a minimum value to a maximum value of a variable. Alternatively, in the implementation of FIG. 2, the SI characteristic value of the data signal (DQ pin) may be measured based on an input of the read enable signal nRE or the data strobe signal DQS, or the SI characteristic value of the data strobe signal (DQS pin) may be measured based on the data signal (DQ pin). For example, in the implementation of FIG. 3, the SI characteristic value of the data signal (DQ pin) may be measured based on a signal of CA[0] or CA[1] or the SI characteristic value of the data signal (DQ pin) may be measured based on a CA_CLK signal. For example, after a variable is set to a preset minimum value (S12), expected data for a test is preset by any one nonvolatile memory device 200 connected to the corresponding channel (S13).

In the preset setting, for example, expected data having a predetermined data pattern is written and stored in the nonvolatile memory device 200, and the storage controller 100 also separately stores the expected data. In the preset setting, for example, a data pattern for which it is easy to detect a defect for each target pin may be variously set as expected data.

The storage controller 100 transmits a read command for the preset expected data under the channel operating condition (S14), and when the corresponding data is read and transmitted from the nonvolatile memory device 200 (S15), the storage controller 100 compares the pre-stored expected data with the test data by using the received data as test data (S16).

When the test data is different from the expected data, the SI quality manager 110 of the storage controller 100 determines that the channel operating condition is not appropriate and records the result of a comparison in the memory 120(S17), that is, the set channel operation condition of S11 is an inoperable setting value.

When the test data is the same as the expected data, the SI quality manager 110 determines the channel operating condition set in S11 as an operable setting value, maps the SI state measured in the corresponding channel to the set channel operating condition based on the test data and records the measured SI state of the corresponding channel in the memory 120 (S17) based on a determination (that is, a comparison result).

It is determined if the variable is at a preset maximum value S18. If not, the variable is increased (e.g. by a predefined amount, such as by one) S20 and steps S14-S18 are repeated. If the present maximum value is reached, then the measurement is terminated S19.

In this way, the operations of S14 to S17 are performed while increasing (or sweeping) from the preset minimum value to a preset maximum value of the variable (S18, S20), so that the SI state under the channel operating condition is recorded in the memory 120, and when the variable reaches the maximum setting value, the measurement is terminated (S19).

Referring to a write operation of FIG. 8 according to one implementation, after the measurement flag is turned on (S50), the storage controller 100 may set the channel operating condition (S51). According to various implementations, the channel operating condition may be set differently for each type of memory access operation (read operation, write operation, erase operation and background operation), or may be set equally regardless of each type of memory access operation.

In the channel set to the channel operating condition, the storage controller 100 may measure the SI characteristic value while sweeping a variable, which affects the SI characteristic value of the SI characteristic to be measured, from a preset minimum value to a preset maximum value. For example, after the variable is set to a preset minimum value (S52), expected data for a test is preset to any one of the nonvolatile memory devices 200 connected to the corresponding channel (S53).

The preset operation may include, for example, storing expected data having a predetermined data pattern in both of the storage controller 100 and the nonvolatile memory device 200.

The storage controller 100 transmits a write command for the preset expected data under the channel operating condition (S54), and when the corresponding data is written in the nonvolatile memory device 200 (S55), the nonvolatile memory device 200 compares the pre-stored expected data with the test data stored by the write command (S56).

The nonvolatile memory device 200 transmits a Pass/Fail (P/F) signal (for example, a flag signal) indicating a comparison result between the expected data and the test data to the storage controller 100. The P/F signal may indicate a 'Pass' if the test data stored by the write command matches the pre-stored expected data. The P/F signal may indicate a 'Fail' if the test data stored by the write command does not match the pre-stored expected data.

When the test data corresponds to 'Fail' based on the P/F signal (when the test data is different from the expected data), the SI quality manager 110 determines that the channel operating condition is not appropriate and records the determined result (that is, a comparison result) in the memory 120 such as the set channel operating condition of S51 is an inoperable setting value (S57).

When the test data corresponds to 'Pass' (when the test data is the same as the expected data), the SI quality manager 110 determines the channel operating condition set in S51 as an operable setting value, maps the SI state measured in the corresponding channel to the set channel operating condition based on the test data and records the measured SI state mapping with the channel operating condition in the memory 120 (S57) according to the determination result.

It is determined if the variable is at a preset maximum value S89. If not, the variable is increased (e.g., by a predefined amount, such as by one) S91 and steps S84-S88 are repeated. If the present maximum value is reached, then the measurement is terminated S90.

In this way, the operations of S54 to S57 are performed while increasing from the preset minimum value to the preset maximum value of the variable (S58, S60), so that the SI state under the channel operating condition is recorded in the memory 120, and when the variable reaches the preset maximum value, the measurement is terminated (S59). While the present embodiment sweeps the variable from a minimum value to a maximum value, alternative embodiments may sweep the variable from a maximum value to a minimum value.

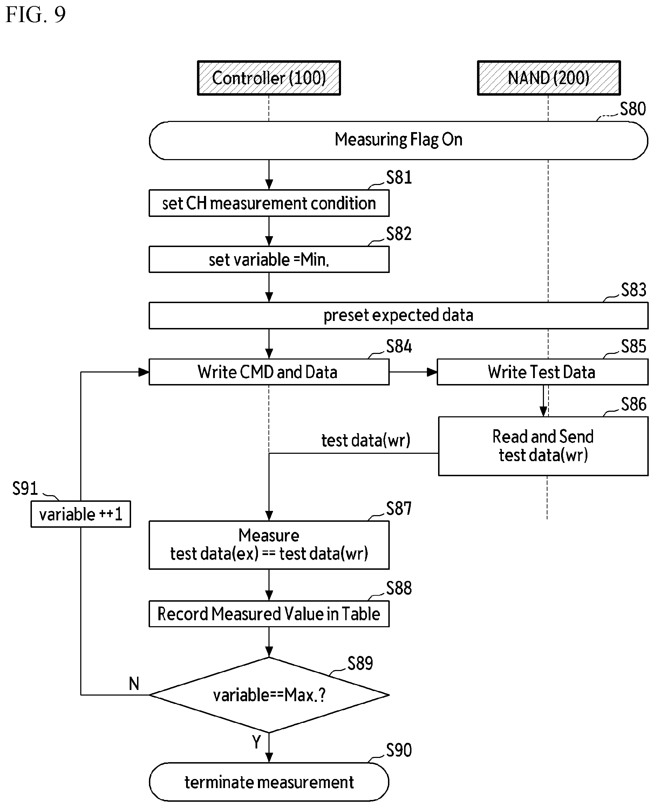

Alternatively, referring to an implementation of a write operation of FIG. 9, unlike the implementation of FIG. 8, written data may be transmitted. Since S80 to S85 of FIG. 9 are redundant with S50 to S55 of FIG. 8, their description will be omitted. When the test data transmitted together with a write command of S85 is written (S86), the nonvolatile memory device 200 reads the written test data by itself and transmits the same to the storage controller 100 (S87).

The SI quality manager 110 of the storage controller 100 compares the pre-stored expected data with the test data by using the received data as the test data (S87). When the test data is different from the expected data, the SI quality manager 110 determines that the corresponding channel operating condition is not appropriate and records the measured SI state mapping with the set channel operating condition of S82 in the memory 120 as an inoperable setting value (S88).

When the test data is the same as the expected data, the SI quality manager 110 determines the channel operating condition set in S81 as an operable setting value, maps the SI state measured in the corresponding channel to the set channel operating condition based on the test data and records the measured SI state mapping with the set channel operating condition of S82 in the memory 120 (S88).

In this way, the operations of S84 to S88 are performed while increasing from the minimum setting value to the maximum setting value of the variable (S89, S91), so that the SI state under the channel operating condition is recorded in the memory 120, and when the variable reaches from the preset minimum value to the preset maximum value(S89), the measurement is terminated (S90). While the present embodiment sweeps the variable from a minimum value to a maximum value, alternative embodiments may sweep the variable from a maximum value to a minimum value.

The SI quality manager 110 may store, for example, the measured SI characteristic value of the first channel in the memory 120. The memory 120 may store the measured value in the form of a table by mapping the channel operating condition of the interface circuit to the SI characteristic value measured in the corresponding condition. The memory 120 is a buffer memory of the storage controller 100, and may be implemented as a volatile memory such as a static random access memory (SRAM) and a dynamic random access memory (DRAM) in accordance with various implementations.

The SI characteristic value may be a window measurement value based on an eye diagram of a signal, as shown in FIG. 3. For example, the SI characteristic value may include a unit time value of a first axis based on a phase locked loop (PLL), a delay locked loop (DLL) or a phase, and/or a voltage level range of a second axis of a voltage swing width of a signal during the operation.

For example, the first interface circuit 141 may set the operating environment to a first channel operating condition Set Con11, then program the expected data to any one nonvolatile memory device in the first memory set 201, map a first SI characteristic value Measured Value11 measured in the first channel CH1 to the first channel operating condition Set Con11 while reading the programmed data, and store the mapped value. For example, the channel operating condition may include at least one of an operation clock frequency, a drive strength-related resistance value (e.g., a drive output resistance of transmitter end, or an output impedance of transmitter end in the channel) or a termination-related resistance value (e.g., termination resistance of receiver end in the channel) of an operation clock generated by a clock generator of the storage controller 100.

Also, for example, the first interface circuit 141 may set the operating environment to a second channel operating condition Set Con12, then program the expected data to any one nonvolatile memory device in the first memory set 201, map a second SI characteristic value Measured Value12 measured in the first channel CH1 to the second channel operating condition (Set Con12) while reading the programmed data, and store the mapped value.

Referring to an example of FIG. 10, a first channel operating condition of the fourth channel CH4 sets operating frequency of 1.2 Ghz, drive strength-related resistance of 25 Ohm and a termination-related resistance of 75 Ohm in the clock generator of the storage controller 100, and measures SI characteristics of the fourth channel by transmitting and receiving data to and from the fourth channel with respect to a nonvolatile memory set. The SI characteristics of the fourth channel may be stored in the memory 120 in the form of a table as shown by measuring a value of 0xAB (or 10 ns) with respect to X-axis and a voltage swing width of 0.45 V with respect to Y-axis.

According to one implementation, the SI quality manager 110 stores the measured SI characteristic value in the memory 120, and then calculates an adjustment channel value ADJ_value corresponding to each SI characteristic value compared to the channel operating condition based on a preset calculation formula.

According to another implementation, the SI quality manager 110 stores the measured SI characteristic value in the memory 120, and then may select an adjustment channel value ADJ_value of a tier, which corresponds to each SI characteristic value compared to the channel operating condition, in the optimal value storage 130 and output the selected adjustment channel value. An adjustment channel value may define or indicate one or more channel operations. For instance, the adjustment channel value may define or indicate at least one of an operation clock frequency, a drive strength-related resistance value (e.g., a drive output resistance, or an output impedance of the transmitter end in the channel CH) or a termination-related resistance value (e.g., termination resistance of the receiver end in the channel CH).

The optimal value storage 130 stores a plurality of optimal adjustment channel values corresponding to a difference value range of a measurement SI state value compared to a preset minimum SI state value under an operable channel operating condition in which the nonvolatile memory devices 201 and 202 may operate.

According to various implementations, the optimal value storage 130 may store the optimal adjustment channel value set by being divided for each tier in accordance with the range of the difference value (=measured SI state value - preset minimum SI state value) to conform to performance and power conditions required by the entire storage system. In other words, the plurality of tiers can be based on different levels of deviation from the preset minimum SI state value.

As an example shown in FIG. 11, it is assumed that, when the range of the difference value of the measured SI state value compared to the preset minimum SI state value is 500ps or more on X-axis and 300mV or more on Y-axis, the operating condition is Tier 1, when the range of the difference value is 300ps or more on X-axis and 150mV or more on Y-axis, the operating condition is Tier 2 and when the range of the difference value is 150ps or more on X-axis and 50mV is or more on Y-axis, the operating condition is Tier 3.

In order for a channel having a PCIe 4.0 x 8 condition to maintain performance of 15.75 GB/s and 100W power, an operating frequency of 2.4 Gbps, a drive strength-related resistance of 15 Ohm and a termination-related resistance of 50 Ohm may be stored as adjustment channel values in Tier 1, an operating frequency of 2.0 Gbps, a drive strength-related resistance of 15 Ohm and a termination-related resistance of 50 Ohm may be stored as adjustment channel values in Tier 2, and an operating frequency of 1.8 Gbps, a drive strength-related resistance of 15 Ohm and a termination-related resistance of 50 Ohm may be stored as adjustment channel values in Tier 3. That is, only the operating frequency may be stored as being different.

Alternatively, in order for a channel having a PCIe 4.0 x 8 condition to maintain performance of 15.75 GB/s and 80W power, an operating frequency of 2.6 Gbps, a drive strength-related resistance of 5 Ohm and a termination-related resistance of 50 Ohm may be stored as adjustment channel values in Tier 1, an operating frequency of 1.9 Gbps, a drive strength-related resistance of 50 Ohm and a termination-related resistance of 75 Ohm may be stored as adjustment channel values in Tier 2, and an operating frequency of 1.6 Gbps, a drive strength-related resistance of 75 Ohm and a termination-related resistance of 75 Ohm may be stored as adjustment channel values in Tier 3. That is, the operating frequency, the drive strength-related resistance and the termination-related resistance may be stored as different values.

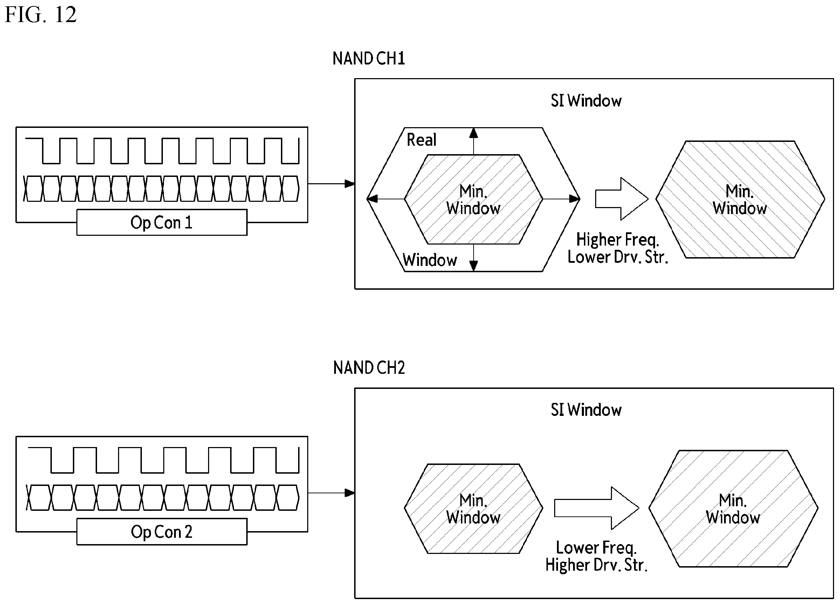

FIG. 12 is an eye diagram illustrating SI characteristic values when a channel-specific adjustment channel value is applied in accordance with an implementation of the present disclosure.

After storing the measured SI characteristic value in the memory 120, the SI quality manager 110 may select an adjustment channel value ADJ_value of a tier, which corresponds to each SI characteristic value compared to a channel operating condition, in the optimal value storage 130 and output the selected adjustment channel value. In the shown example of FIG. 6, the SI quality manager 110 may set each of the interface circuits 141 and 142 to the adjustment channel values ADJ_value1 and ADJ_value2 adaptively selected for each channel.

Referring to FIG. 12, the first channel may operate by being set to the adjustment channel value ADJ_value1 corresponding to a first channel operating condition Op Con1, and the second channel may operate by being set to the adjustment channel value ADJ_value2 corresponding to a second channel operating condition Op Con2. That is, since the channels are set independently in accordance with the operating environments of the channels, the first channel may be adjusted to a higher first operating frequency and a lower first drive strength-related resistance so that the eye diagram based on the SI characteristic value may be improved to be smaller. Meanwhile, the second channel may be adjusted to a lower second frequency and a higher second drive strength-related resistance so that the eye diagram based on the SI characteristic value may be improved to be larger.

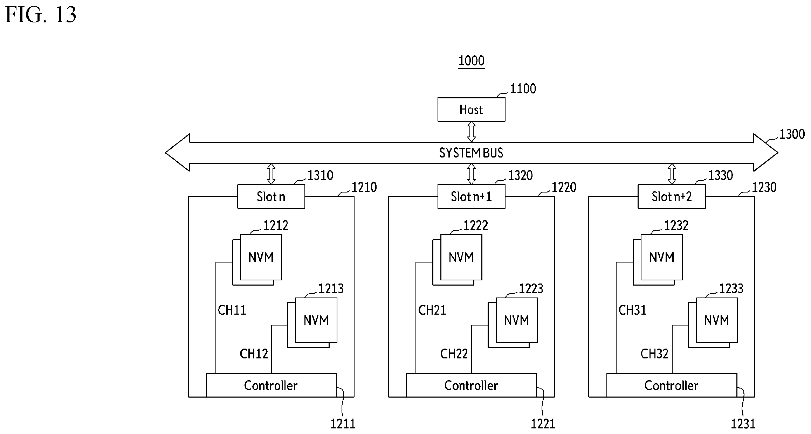

FIG. 13 is a block diagram illustrating a data server system 1000 according to another implementation of the present disclosure.

The data server system 1000 includes a host 1100, a plurality of storage devices 1210, 1220 and 1230, and a system bus 1300 connecting the host to the storage devices. The storage devices may be implemented as the storage device 1 of FIG. 1. Each of the storage devices 1210, 1220 and 1230 may be connected to the system bus 1300 through slots 1310, 1320 and 1330.

The host 1100 may measure the SI state value based on slot operating conditions variously set for each slot. The host 1100 may independently set an adjustment setting value for each slot based on the measured SI state value of the slot due to the set slot operating conditions. For example, as the adjustment channel value is set in FIGS. 6 to 12 described above, an interface circuit for the slot may be set by the slot adjustment setting value for each slot to maintain minimum performance and power for each operating environment.

Accordingly, the host 1100 may efficiently perform communication with the storage devices 1210, 1220 and 1230 connected to each slot.

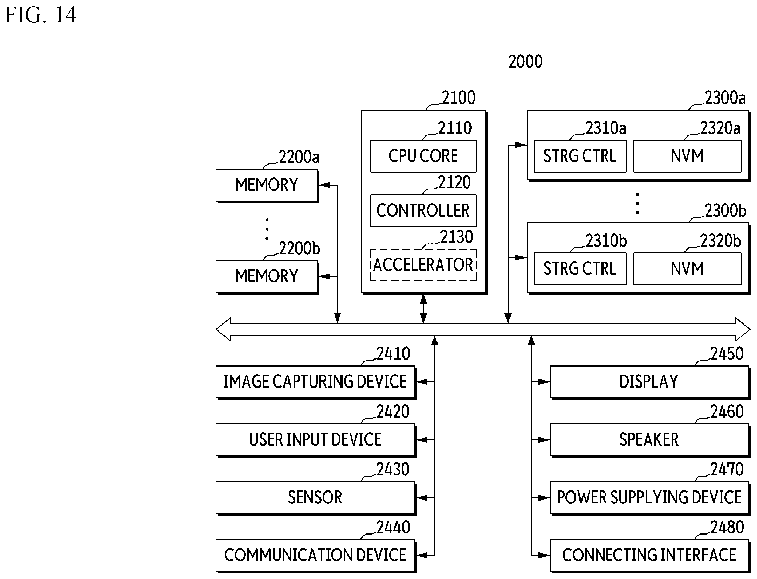

FIG. 14 is a diagram illustrating a system 2000 to which a storage device according to one implementation of the present disclosure is applied.

The system 2000 of FIG. 14 may be a mobile system such as a mobile communication terminal (e.g., mobile phone), a smart phone, a tablet personal computer (PC), a wearable device, a healthcare device, or an Internet of things (IOT) device. However, the system 2000 of FIG. 22 is not necessarily limited to the mobile system, and may be a personal computer, a laptop computer, a server, a media player, or an automotive device (e.g., a navigator).

Referring to FIG. 14, the system 2000 may include a main processor 2100, memories 2200a and 2200b, and storage devices 2300a and 2300b. The system 2000 may further include one or more of an image capturing device 2410, a user input device 2420, a sensor 2430, a communication device 2440, a display 2450, a speaker 2460, a power supplying device 2470 and a connecting interface 2480.

The main processor 2100 may control the overall operation of the system 2000, in more detail, the operation of other components constituting the system 2000. The main processor 2100 may be implemented as a general purpose processor, a dedicated processor, or an application processor.

The main processor 2100 may include one or more CPU cores 2110, and may further include a controller 2120 for controlling the memories 2200a and 2200b and/or the storage devices 2300a and 2300b. In some implementations, the main processor 2100 may further include an accelerator 2130 that is a dedicated circuit for high-speed data computation such as artificial intelligence (AI) data computation. The accelerator 2130 may include a graphics processing unit (GPU), a neural network processing unit (NPU), and/or a data processing unit (DPU), and may be implemented as a separate chip physically separated from other components of the main processor 2100.

The memories 2200a and 2200b may be used as main memory devices of the system 2000, and may include a volatile memory such a static random access memory (SRAM) and/or a dynamic random access memory (DRAM), but may also include a nonvolatile memory such as a flash memory, a stage-change RAM (PRAM) and/or a resistive RAM. The memories 2200a and 2200b may be implemented in the same package as the main processor 2100.

The storage devices 2300a and 2300b may serve as nonvolatile storage devices for storing data regardless of whether power is supplied, and may have a storage capacity relatively greater than that of the memories 2200a and 2200b. The storage devices 2300a and 2300b may include storage controllers 2310a and 2310b and nonvolatile memories (NVM) 2320a and 2320b for storing data under the control of the storage controllers 2310a and 2310b. The nonvolatile memories 2320a and 2320b may include a flash memory having a two-dimensional (2D) structure or a three-dimensional (3D) Vertical NAND (V-NAND) structure, but may also include other types of nonvolatile memories such as a PRAM and/or an RRAM.

The storage devices 2300a and 2300b may be included in the system 2000 in a physically separated state from the main processor 2100, and may be implemented in the same package as the main processor 2100. In addition, the storage devices 2300a and 2300b may have a type of a solid state device (SSD) or a memory card, and may be detachably coupled to other components of the system 2000 through an interface such as the connecting interface 2480 that will be described later. Such storage devices 2300a and 2300b may be, but are not limited to, devices to which standard protocols such as a Universal Flash Storage (UFS), an embedded Multi-Media Card (eMMC) or a Nonvolatile Memory express (NVMe) are applied.

The image capturing device 2410 may capture a still image or a video, and may be a camera, a camcorder and/or a webcam.

The user input device 2420 may receive various types of data input from a user of the system 2000, and may include a touch pad, a keypad, a keyboard, a mouse and/or a microphone.

The sensor 2430 may sense various types of physical quantities that may be acquired from the outside of the system 2000, and may convert the sensed physical quantities into an electrical signal. The sensor 2430 may be a temperature sensor, a pressure sensor, an illuminance sensor, a position sensor, an acceleration sensor, a biosensor and/or a gyroscope sensor.

The communication device 2440 may perform transmission and reception of signals between other devices outside the system 2000 in accordance with various communication protocols. The communication device 2440 may include an antenna, a transceiver and/or a modem.

The display 2450 and the speaker 2460 may serve as output devices configured to output visual information and auditory information to a user of the system 2000, respectively.

The power supplying device 2470 may appropriately convert power supplied from an external power source and/or a battery (not shown) embedded in the system 2000 to supply the converted power to each component of the system 2000.

The connecting interface 2480 may provide connection between the system 2000 and an external device connected to the system 2000 to transmit and receive data to and from the system 2000. The connecting interface 2480 may be implemented in a variety of interface modes such as Advanced Technology Attachment (ATA), Serial ATA (SATA), external SATA (e-SATA), Small Computer Small Interface (SCSI), Serial Attached SCSI (SAS), Peripheral Component Interconnection (PCI), PCI express (PCIe), NVM express (NVMe), IEEE 1394, universal serial bus (USB), Secure Digital (SD) card, Multi-Media Card (MMC), embedded multi-media card (eMMC), Universal Flash Storage (UFS), embedded Universal Flash Storage (eUFS), and Compact Flash (CF) card interface.

Embodiments are set out in the following Clauses:
Clause 1. A storage system comprising:
   a first memory set including a plurality of first nonvolatile memory devices and configured to communicate through a first channel;
   a second memory set including a plurality of second nonvolatile memory devices and configured to communicate through a second channel; and
   a storage controller including a first interface circuit connected to the first channel and a second interface circuit connected to the second channel,
   wherein the storage controller is configured to
      measure, under a preset channel operating condition, a first signal integrity (SI) state of the first channel and a second SI state of the second channel,
      set, based on a first adjustment channel value, a first channel operating condition of the first channel, the first adjustment channel value being based on the first SI state, and
      set, based on a second adjustment channel value, a second channel operating condition of the second channel, the second adjustment channel value being based on the second SI state.
Clause 2. The storage system of Clause 1, wherein for measuring the first SI state and the second SI state, the storage controller is configured to
   set an initial channel operating condition and
   measure a value of an eye diagram for a respective signal during an operation of each of the first channel and the second channel.
Clause 3. The storage system of Clause 2, wherein the value of the eye diagram comprises
   a unit time value based on a phase locked loop (PLL), a delay locked loop (DLL) and/or a phase, and
   a range of a voltage swing width of the respective signal.
Clause 4. The storage system of any preceding Clause, wherein the storage controller comprises:
   a memory configured to store the first and second SI states; and
   an SI quality manager configured to set the first interface circuit by transmitting the first adjustment channel value, and set the second interface circuit by transmitting the second adjustment channel value.
Clause 5. The storage system of Clause 4, wherein the SI quality manager is configured to
   calculate the first adjustment channel value based on a first difference level between the first SI state and a preset minimum SI state, and
   calculate the second adjustment channel value based on a second difference level between the second SI state and the preset minimum SI state.
Clause 6. The storage system of Clause 4 or Clause 5, wherein the storage controller includes an optimal value storage device configured to store a plurality of adjustment channel values corresponding to a plurality of tiers of operating conditions, the plurality of tiers of operating conditions being based on different levels of deviation from a preset minimum SI state.
Clause 7. The storage system of Clause 6, wherein the SI quality manager is configured to
   output the first adjustment channel value of the plurality of adjustment channel values in the optimal value storage device that corresponds to a first tier of the plurality of tiers, the first tier corresponding to a first difference level between the first SI state and the preset minimum SI state, and
   output the second adjustment channel value of the plurality of adjustment channel values in the optimal value storage device that corresponds to a second tier of the plurality of tiers, the second tier corresponding to a second difference level between the second SI state and the preset minimum SI state.
Clause 8. An operating method of a storage controller, the storage controller including a first interface circuit connected to a first channel that is configured to perform communication with a plurality of first nonvolatile memory devices and a second interface circuit connected to a second channel that is configured to perform communication with a plurality of second nonvolatile memory devices, the operating method comprising:
   measuring signal integrity (SI) states based on at least one channel operating condition of each of the first channel and the second channel;
   outputting a first adjustment channel value based on a first difference level between a first SI state of the first channel of the SI states and a preset minimum SI state;
   outputting a second adjustment channel value based on a second difference level between a second SI state of the second channel of the SI states and the preset minimum SI state;
   setting the first interface circuit for the first channel to the first adjustment channel value; and
   setting the second interface circuit for the second channel to the second adjustment channel value.
Clause 9. The operating method of Clause 8, comprising:
   setting a first channel operating condition in the first channel and a second channel operating condition in the second channel;
   presetting expected data in at least one of the plurality of first nonvolatile memories and at least one of the plurality of second nonvolatile memories;
   receiving test data by the at least one of the plurality of first nonvolatile memories and the at least one of the plurality of second nonvolatile memories; and
   measuring and storing the first SI state corresponding to the first channel operating condition of the first channel and the second SI state corresponding to the second channel operating condition of the second channel.
Clause 10. The operating method of Clause 9, comprising:
   recording, based on the test data being equal to the expected data, the first channel operating condition of the first channel as an operable setting value;
   measuring a plurality of SI states of the first channel that respectively correspond to a plurality of variable values of the first channel operating condition, the plurality of variable values ranging from a preset minimum variable value to a preset maximum variable value; and storing the plurality of SI states of the first channel.
Clause 11. The operating method of any of Clauses 8-10, wherein the first and second SI states include:
   a unit time value based on a phase locked loop (PLL), a delay locked loop (DLL), and/or a phase of an eye diagram of each of the first and second channels; and
   a voltage level range of a voltage swing width of a signal during an operation.
Clause 12. The operating method of any of Clauses 8-11, wherein the first adjustment channel value and the second adjustment channel value are different, and the first adjustment channel value and the second adjustment channel value are based on the SI states of the first and second channels, respectively.
Clause 13. A storage system comprising:
   a plurality of memory sets each including a plurality of nonvolatile memory devices, the plurality of nonvolatile memory devices of each memory set being connected to one another through a respective channel of a plurality of channels; and
   a storage controller including a plurality of interface circuits respectively connected to the plurality of channels, the storage controller being configured to set each of the plurality of interface circuits based on a corresponding adjustment channel value of adjustment channel values,
   wherein each of the adjustment channel values is based on a difference between a respective signal integrity (SI) state during an operation of a respective channel of the plurality of channels and a preset minimum SI state based on a preset channel operating condition.
Clause 14. The storage system of Clause 13, wherein the storage controller includes an optimal value storage device that is configured to store the adjustment channel values, the adjustment channel values respectively corresponding to a plurality of tiers of operating conditions, the plurality of tiers being based on different levels of deviation from the preset minimum SI state.
Clause 15. The storage system of Clause 13 or Clause 14, wherein the storage controller is configured to:
   set a channel operating condition of a first channel of the plurality of channels;
   set a variable of the SI state of the first channel as a preset minimum value;
   preset expected data in a first memory set that is connected to the first channel;
   perform an access operation to the expected data in the first memory set;
   compare a first test data received from the first memory set to the expected data;
   measure a first SI state of the first channel based on a result of the comparison; and
   record the first SI state of the first channel mapping with the set channel operating condition based on the result of the comparison.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A storage system comprising:
a first memory set (201) including a plurality of first nonvolatile memory devices and configured to communicate through a first channel (CH1);
a second memory set (202) including a plurality of second nonvolatile memory devices and configured to communicate through a second channel (CH2); and
a storage controller (100) including a first interface circuit (141) connected to the first channel (CH1) and a second interface circuit (142) connected to the second channel (CH2),
wherein the storage controller (100) is configured to:
measure, under a preset channel operating condition, a first signal integrity, SI, state of the first channel (CH1) and a second SI state of the second channel (CH2);
set, based on a first adjustment channel value, a first channel operating condition of the first channel (CH1), the first adjustment channel value being based on the first SI state; and
set, based on a second adjustment channel value, a second channel operating condition of the second channel (CH2), the second adjustment channel value being based on the second SI state.

2. The storage system of claim 1, wherein for measuring the first SI state and the second SI state, the storage controller (100) is configured to:
set an initial channel operating condition; and
measure a value of an eye diagram for a respective signal during an operation of each of the first channel (CH1) and the second channel (CH2).

3. The storage system of claim 2, wherein the value of the eye diagram comprises:
a unit time value based on a phase locked loop, a delay locked loop, and/or a phase, and
a range of a voltage swing width of the respective signal.

4. The storage system of any preceding claim, wherein the storage controller (100) comprises:
a memory (120) configured to store the first and second SI states; and
an SI quality manager (110) configured to configure the first interface circuit (141) by transmitting the first adjustment channel value, and configure the second interface circuit (142) by transmitting the second adjustment channel value.

5. The storage system of claim 4, wherein the SI quality manager (110) is configured to:
calculate the first adjustment channel value based on a first difference level between the first SI state and a preset minimum SI state; and
calculate the second adjustment channel value based on a second difference level between the second SI state and the preset minimum SI state.

6. The storage system of claim 4 or claim 5, wherein the storage controller (100) includes an optimal value storage device (130) configured to store a plurality of adjustment channel values corresponding to a plurality of tiers of operating conditions, the plurality of tiers of operating conditions being based on different levels of deviation from a preset minimum SI state.

7. The storage system of claim 6, wherein the SI quality manager (110) is configured to
output the first adjustment channel value of the plurality of adjustment channel values in the optimal value storage device (130) that corresponds to a first tier of the plurality of tiers, the first tier corresponding to a first difference level between the first SI state and the preset minimum SI state, and
output the second adjustment channel value of the plurality of adjustment channel values in the optimal value storage device (130) that corresponds to a second tier of the plurality of tiers, the second tier corresponding to a second difference level between the second SI state and the preset minimum SI state.

8. An operating method of a storage controller, the storage controller including a first interface circuit (141) connected to a first channel (CH1) that is configured to perform communication with a plurality of first nonvolatile memory devices (210) and a second interface circuit (142) connected to a second channel (CH2) that is configured to perform communication with a plurality of second nonvolatile memory devices (202), the operating method comprising:
measuring signal integrity, SI, states based on at least one channel operating condition of each of the first channel (CH1) and the second channel (CH2);
outputting a first adjustment channel value based on a first difference level between a first SI state of the first channel (CH1) of the SI states and a preset minimum SI state;
outputting a second adjustment channel value based on a second difference level between a second SI state of the second channel (CH2) of the SI states and the preset minimum SI state;
setting the first interface circuit (141) for the first channel (CH1) to the first adjustment channel value; and
setting the second interface circuit (142) for the second channel (CH2) to the second adjustment channel value.

9. The operating method of claim 8, comprising:
setting a first channel operating condition in the first channel (CH1) and a second channel operating condition in the second channel (CH2);
presetting expected data in at least one of the plurality of first nonvolatile memories (201) and at least one of the plurality of second nonvolatile memories (202);
receiving test data by the at least one of the plurality of first nonvolatile memories (201) and the at least one of the plurality of second nonvolatile memories (202); and
measuring and storing the first SI state corresponding to the first channel operating condition of the first channel (CH1) and the second SI state corresponding to the second channel operating condition of the second channel (CH2).

10. The operating method of claim 9, comprising:
recording, based on the test data being equal to the expected data, the first channel operating condition of the first channel (CH1) as an operable setting value;
measuring a plurality of SI states of the first channel (CH1) that respectively correspond to a plurality of variable values of the first channel operating condition, the plurality of variable values ranging from a preset minimum variable value to a preset maximum variable value; and
storing the plurality of SI states of the first channel (CH1).

11. The operating method of any of claims 8-10, wherein the first and second SI states include:
a unit time value based on a phase locked loop, a delay locked loop, and/or a phase of an eye diagram of each of the first and second channels; and
a voltage level range of a voltage swing width of a signal during an operation.

12. The operating method of any of claims 8-11, wherein the first adjustment channel value and the second adjustment channel value are different, and the first adjustment channel value and the second adjustment channel value are based on the SI states of the first and second channels (CH1, CH2), respectively.

13. A storage system comprising:
a plurality of memory sets (201, 202) each including a plurality of nonvolatile memory devices, the plurality of nonvolatile memory devices of each memory set being connected to one another through a respective channel of a plurality of channels (CH1, CH2); and
a storage controller (100) including a plurality of interface circuits (141, 142) respectively connected to the plurality of channels (CH1, CH2), the storage controller (100) being configured to configure each of the plurality of interface circuits (141, 142) based on a corresponding adjustment channel value of adjustment channel values,
wherein each of the adjustment channel values is based on a difference between a respective signal integrity, SI, state during an operation of a respective channel of the plurality of channels (CH1, CH2) and a preset minimum SI state based on a preset channel operating condition.

14. The storage system of claim 13, wherein the storage controller (100) includes an optimal value storage device (130) that is configured to store the adjustment channel values, the adjustment channel values respectively corresponding to a plurality of tiers of operating conditions, the plurality of tiers being based on different levels of deviation from the preset minimum SI state.

15. The storage system of claim 13 or claim 14, wherein the storage controller (100) is configured to:
set a channel operating condition of a first channel (CH1) of the plurality of channels (CH1, CH2);
set a variable of the SI state of the first channel (CH1) as a preset minimum value;
preset expected data in a first memory set (201) that is connected to the first channel (CH1);
perform an access operation to the expected data in the first memory set (201);
compare a first test data received from the first memory set (201) to the expected data;
measure a first SI state of the first channel (CH1) based on a result of the comparison; and
record a mapping of the first SI state of the first channel to the set channel operating condition based on the result of the comparison.
